# EUROPÄISCHE PATENTSCHRIFT

(11) **EP 2 923 528 B1**
(45) Veröffentlichungstag und Bekanntmachung des Hinweises auf die Patenterteilung: **04.01.2017**
(21) Anmeldenummer: 13739194.2
(22) Anmeldetag: 16.07.2013
(51) Int. Cl.: H05B 3/84

(54) **SCHEIBE MIT ELEKTRISCHEM ANSCHLUSSELEMENT UND VERBINDUNGSSTEG**
DISC WITH ELECTRIC CONNECTION ELEMENT AND CONNECTING ARM
DISQUE AVEC ÉLÉMENT DE RACCORDEMENT ÉLECTRIQUE ET BARRETTE DE LIAISON

(30) Priorität: 21.11.2012 EP 12193522
(43) Veröffentlichungstag der Anmeldung: 30.09.2015
(73) Patentinhaber: Saint-Gobain Glass France, 92400 Courbevoie (FR)
(72) Erfinder: SCHMALBUCH, Klaus, 52074 Aachen (DE); REUL, Bernhard, 52134 Herzogenrath (DE); RATEICZAK, Mitja, 52146 Würselen (DE); LESMEISTER, Lothar, NL-6373 Landgraaf (NL)
(74) Vertreter: Gebauer, Dieter Edmund
(86) Internationale Anmeldenummer: PCT/EP2013/064987
(87) Internationale Veröffentlichungsnummer: WO 2014/079594

(56) Entgegenhaltungen:
- EP-A1- 2 408 260
- WO-A1-2007/110610
- DE-A1-102009 016 353
- US-A- 4 023 008

## Beschreibung

Die Erfindung betrifft eine Scheibe mit einem elektrischen Anschlusselement, ein wirtschaftliches und umweltfreundliches Verfahren zu deren Herstellung und deren Verwendung.

Die Erfindung betrifft weiter eine Scheibe mit einem elektrischen Anschlusselement für Fahrzeuge mit elektrisch leitfähigen Strukturen wie beispielsweise Heizleiter oder Antennenleiter. Die elektrisch leitfähigen Strukturen sind üblicherweise über angelötete elektrische Anschlusselemente mit der Bordelektrik verbunden. Aufgrund unterschiedlicher thermischer Ausdehnungskoeffizienten der verwendeten Materialien treten mechanische Spannungen bei der Herstellung und im Betrieb auf, welche die Scheiben belasten und den Bruch der Scheibe hervorrufen können.

Bleihaltige Lote weisen eine hohe Duktilität auf, die auftretende mechanische Spannungen zwischen elektrischem Anschlusselement und der Scheibe durch plastische Deformierung kompensieren können. Allerdings müssen aufgrund der Altauto-Richtlinie 2000/53/EG innerhalb der EG bleihaltige Lote durch bleifreie Lote ersetzt werden. Die Richtlinie wird zusammenfassend mit dem Kürzel ELV (End of life vehicles) bezeichnet. Das Ziel ist dabei, im Zuge der massiven Ausweitung von Wegwerfelektronik äußerst problematische Bestandteile aus den Produkten zu verbannen. Die betroffen Substanzen sind Blei, Quecksilber, Cadmium und Chrom. Das betrifft unter anderem die Durchsetzung von bleifreien Lötmitteln in elektrischen Anwendungen auf Glas und die Einführung entsprechender Ersatzprodukte hierzu.

Die bisher bekannten bleifreien Lotmassen, wie beispielsweise in EP 2 339 894 A1 und WO 2000058051 offenbart, sind jedoch aufgrund ihrer niedrigeren Duktilität nicht in gleichem Maße wie Blei in der Lage mechanische Spannungen zu kompensieren. Die üblichen kupferhaltigen Anschlusselemente weisen jedoch einen größeren thermischen Ausdehnungskoeffizienten auf als Glas (CTE(Kupfer) = 16,8 x 10⁻⁶/°C), wodurch bei einer thermischen Ausdehnung des Kupfers eine Schädigung am Glas stattfindet. Aus diesem Grund werden in Verbindung mit bleifreien Lotmassen bevorzugt Anschlusselemente verwendet, die einen niedrigen thermischen Ausdehnungskoeffizienten, bevorzugt in der Größenordnung von Kalk-Natron-Glas (8,3 x 10⁻⁶/°C für 0 °C - 320 °C), aufweisen. Derartige Anschlusselemente dehnen sich bei Erwärmung kaum aus und kompensieren die entstehenden Spannungen.

EP 1 942 703 A2 offenbart ein elektrisches Anschlusselement an Scheiben von Fahrzeugen, wobei die Differenz der thermischen Ausdehnungskoeffizienten von Scheibe und elektrischem Anschlusselement < 5 x 10⁻⁶/°C beträgt und das Anschlusselement überwiegend Titan enthält. Um eine ausreichende mechanische Stabilität und Prozessierbarkeit zu ermöglichen wird vorgeschlagen, einen Lotmassenüberschuss zu verwenden. Der Überschuss an Lotmasse tritt aus dem Zwischenraum zwischen dem Anschlusselement und elektrisch leitfähiger Struktur heraus. Der Überschuss an Lotmasse verursacht hohe mechanische Spannungen in der Glasscheibe. Diese mechanischen Spannungen führen schließlich zum Bruch der Scheibe. Zudem ist Titan schlecht lötbar. Dies führt zu einer schlechten Haftung des Anschlusselementes an der Scheibe. Das Anschlusselement muss außerdem mit der Bordelektrik über ein elektrisch leitfähiges Material, beispielsweise Kupfer, verbunden werden, etwa durch Verschweißen. Titan ist schlecht schweißbar.

EP 2 408 260 A1 beschreibt die Verwendung von Eisen-Nickel- oder Eisen-Nickel-Kobalt-Legierungen wie beispielsweise Kovar oder Invar, die einen niedrigen thermischen Ausdehnungskoeffizienten (CTE) besitzen. Sowohl Kovar (CTE = 5 x 10⁻⁶/°C) als auch Invar (CTE bis zu 0,55 x 10⁻⁶/°C je nach Zusammensetzung) weisen einen niedrigeren CTE auf als Kalk-Natron-Glas und kompensieren die mechanischen Spannungen. Invar weist dabei einen so niedrigen thermischen Ausdehnungskoeffizienten auf, dass eine Überkompensation dieser mechanischen Spannungen eintritt. Dies führt zu Druckspannungen im Glas bzw. Zugspannungen in der Legierung, die allerdings als unkritisch einzustufen sind.

Eine elektrische Verbindung des Anschlusselements mit der Bordelektronik erfolgt im Allgemeinen über einen Verbindungssteg, an den über ein Kabel oder ähnliches die Bordspannung angelegt wird. Dieser Verbindungssteg ist nach dem Stand der Technik einteilig mit dem Anschlusselement ausgeformt und verläuft parallel zu den Füßen des Anschlusselements. Wie in WO 2007/110610 A1 beschrieben sollte die Geometrie des einteiligen Anschlusselements mit Verbindungssteg dahingehend optimiert werden, dass möglichst geringe Spannungen an der Lötstelle auftreten.

Da die Position des Verbindungsstegs nach Einbau der Verglasung oft nur schwer zugänglich ist wird der Verbindungssteg häufig so vorgebogen, dass dieser senkrecht nach oben weist. Bei einteilig ausgeformten kupferhaltigen Anschlusselementen mit Verbindungssteg kann diese Umformung des Verbindungsstegs aufgrund der Plastizität des Materials sehr einfach durchgeführt werden. Diese sind jedoch aufgrund des hohen thermischen Ausdehnungskoeffizientens von Kupfer kaum für die Verlötung mit bleifreien Lotmassen auf Glas geeignet. Für die Verwendung mit bleifreien Lotmassen geeignetere Materialien wie beispielsweise Stahl-Legierungen oder Titan weisen eine wesentlich höhere Härte auf als Kupfer, wodurch eine Umformung des Verbindungsstegs erheblich erschwert ist.

Die Aufgabe der vorliegenden Erfindung ist es, eine Scheibe mit elektrischem Anschlusselement und Verbindungssteg sowie ein wirtschaftliches und umweltfreundliches Verfahren zu deren Herstellung bereitzustellen, wobei kritische mechanische Spannungen in der Scheibe vermieden werden und die Stegposition mit einfachen Mitteln nachträglich justierbar ist.

Die Aufgabe der vorliegenden Erfindung wird erfindungsgemäß durch eine Scheibe mit Anschlusselement, ein Verfahren zu deren Herstellung und deren Verwendung gemäß den unabhängigen Ansprüchen 1, 13 und 15 gelöst. Bevorzugte Ausführungen gehen aus den Unteransprüchen hervor.

Die Aufgabe der vorliegenden Erfindung wird erfindungsgemäß durch eine Scheibe mit mindestens einem Anschlusselement mit Verbindungssteg gelöst, wobei die Materialzusammensetzungen des Anschlusselements und des Verbindungsstegs sich unterscheiden. Die Anordnung umfasst dabei mindestens ein Substrat mit elektrisch leitfähiger Struktur auf mindestens einem Teilbereich des Substrats, mindestens ein elektrisches Anschlusselement auf mindestens einem Teilbereich der elektrisch leitfähigen Struktur, einen Verbindungssteg auf mindestens einem Teilbereich des Anschlusselements und eine bleifreie Lotmasse, die das elektrische Anschlusselement in mindestens einem Teilbereich mit der elektrisch leitfähigen Struktur verbindet. Die Materialzusammensetzung des Anschlusselements wird dabei so ausgewählt, dass die Differenz der thermischen Ausdehnungskoeffizienten des Substrats und des Anschlusselements kleiner 5 x 10⁻⁶/°C ist. Dadurch werden die thermischen Spannungen der Scheibe reduziert und eine bessere Haftung erreicht. Materialien, die einen geeigneten thermischen Ausdehnungskoeffizienten aufweisen verfügen jedoch oft über eine hohe Festigkeit und/oder einen hohen elektrischen Widerstand. Eine hohe Festigkeit des Verbindungsstegs erschwert allerdings ein Umformen, wodurch die Möglichkeiten zur nachträglichen Justierung der Stegposition mittels Hochbiegen des Verbindungsstegs begrenzt sind. Ein hoher elektrischer Widerstand des Verbindungsstegs ist ebenfalls nachteilig, da im Einbauzustand über das Anschlusselement eine Spannung an die elektrisch leitfähige Struktur angelegt werden soll und ein höherer elektrischer Widerstand bei gleicher Spannung einen niedrigeren Stromfluss hervorruft. Bei den nach dem Stand der Technik bekannten einteiligen Anschlusselementen mit direkt angeformtem Verbindungssteg sind Anschlusselement und Verbindungssteg zwangsläufig aus dem gleichen Material, so dass das Anschlusselement entweder einen passenden thermischen Ausdehnungskoeffizienten aufweist, während der Verbindungssteg eine zu hohe Festigkeit und/oder zu niedrige Leitfähigkeit besitzen oder umgekehrt. Das erfindungsgemäße zweiteilig ausgeformte Anschlusselement mit Verbindungssteg ermöglicht hingegen die Kombination verschiedener Materialien, so dass das Anschlusselement selbst aus einem Material mit passendem Ausdehnungskoeffizienten (Differenz zum CTE des Substrats kleiner 5 x 10⁻⁶/°C) beschaffen ist, während der Verbindungssteg aus einem kupferhaltigen Material besteht, das eine ausreichend gute Umformbarkeit besitzt. Dadurch, dass die Materialzusammensetzungen des Anschlusselements und des Verbindungsstegs unterschiedlich gewählt werden, können die Materialien beider Bauteile optimal an die entsprechenden Anforderungen angepasst werden. Der erfindungsgemäße Verbindungssteg enthält Kupfer und ist massiv ausgeformt. Dadurch ist dieser einerseits gut umformbar und gleichzeitig nicht biegeschlaff. Ein leicht umformbarer Verbindungssteg kann mit geringem Kraftaufwand in die gewünschte Position gebogen werden. Dadurch kann dieser Vorgang manuell durchgeführt werden. Die massive Ausführung des Verbindungsstegs stellt sicher, dass dieser nach der Umformung auch in der entsprechenden Position verbleibt. Dadurch wird vermieden, dass beim Einbau der Scheibe oder bei Kontaktierung des Verbindungsstegs auftretende kleinere Kräfte dessen Position verändern. Auf diese Weise ergibt sich eine auch im Einbauzustand der Scheibe gut zugängliche genau definierte Stegposition. Ferner werden nicht massive biegeschlaffe Formen, wie Kabel oder Flachleiter, ausgeschlossen, die zur Verwendung als Verbindungssteg vollkommen ungeeignet sind. Der elektrische Widerstand des Verbindungsstegs wird erfindungsgemäß so gewählt, dass ein hoher Spannungsabfall am Verbindungssteg vermieden wird. Das erfindungsgemäße Anschlusselement mit Verbindungssteg nutzt somit aufgrund seiner zweiteiligen Form die vorteilhaften Eigenschaften der an der entsprechenden Stelle verwendeten Materialien optimal aus und umgeht die Nachteile der nach dem Stand der Technik bekannten einteiligen Anschlusselemente.

Das Anschlusselement mit Verbindungssteg ist mehrteilig, mindestens zweiteilig, ausgeformt, wobei das Anschlusselement und der Verbindungssteg jeweils mindestens ein Bauteil bilden. In einer bevorzugten Ausführungsform ist das Anschlusselement mit Verbindungssteg zweiteilig ausgeformt, so dass das Anschlusselement und der Verbindungssteg aus jeweils einem Bauteil bestehen. Alternativ können das Anschlusselement und der Verbindungssteg auch jeweils aus beliebig vielen Einzelteilen bestehen.

In einer bevorzugten Ausführungsform verfügt die kupferhaltige Materialzusammensetzung des Verbindungsstegs über einen elektrischen Widerstand zwischen 0,5 µOhm·cm und 20 µOhm·cm, bevorzugt zwischen 1,0 µOhm·cm und 15 µOhm·cm, besonders bevorzugt zwischen 1,5 µOhm·cm und 11 µOhm·cm. Dadurch ergibt sich eine besonders vorteilhafte Kombination aus einem Anschlusselement mit an das Substrat angepasstem CTE und einem Verbindungssteg mit verbesserter Leitfähigkeit. Vergleichbare einteilige Anschlusselemente nach dem Stand der Technik, die ebenfalls einen zum Substrat passenden Ausdehnungskoeffizienten aufweisen, verfügen über höhere elektrische Widerstände des Verbindungsstegs, so dass ein unvorteilhaft erhöhter Spannungsabfall auftritt.

Das Anschlusselement weist mindestens eine Kontaktfläche auf über die das Anschlusselement mittels der bleifreien Lotmasse vollflächig mit einem Teilbereich der elektrisch leitfähigen Struktur verbunden ist. In einer bevorzugten Ausführungsform ist das Anschlusselement brückenförmig ausgeprägt, wobei das Anschlusselement über zwei Füße zur Kontaktierung der elektrisch leitfähigen Struktur verfügt, zwischen denen ein erhöhter Abschnitt liegt, der die elektrisch leitfähige Struktur nicht direkt flächig kontaktiert. Auf diesem brückenförmig erhöhten Abschnitt wird bevorzugt der Verbindungssteg angebracht. Das Anschlusselement kann sowohl eine einfache Brückenform aufweisen als auch komplexere Brückenformen umfassen. Dabei ist beispielsweise eine Hantelform mit abgerundeten Füßen denkbar, die sowohl eine gleichmäßige Zugspannungsverteilung bewirken als auch eine gleichmäßige Lotverteilung ermöglichen. Bevorzugt werden Anschlusselemente mit längs ausgeformten Lötfüßen verwendet, wobei die Füße des Anschlusselements in die gleiche Richtung weisen wie der auf dem Anschlusselement aufgebrachte Verbindungssteg. Ein derartiges Design führt zu einer vorteilhaften Erhöhung der Abzugskraft. Auch in dieser Ausführungsform können die Ecken des Anschlusselements im Bereich der Kontaktflächen abgerundet sein, so dass sowohl eine gleichmäßige Verteilung des Lots stattfindet als auch Maximalwerte der Zugspannungen an den Ecken vermieden werden.

Der thermische Ausdehnungskoeffizient des Anschlusselements liegt bevorzugt zwischen 9 x 10⁻⁶/°C und 13 x 10⁻⁶/°C, besonders bevorzugt zwischen 10 x 10⁻⁶/°C und 11,5 x 10⁻⁶/°C, ganz besonders bevorzugt von 10 x 10⁻⁶/°C und 11 x 10⁻⁶/°C und insbesondere zwischen 10 x 10⁻⁶/°C und 10,5 x 10⁻⁶/°C in einem Temperaturbereich von 0 °C bis 300 °C.

Das Anschlusselement verfügt im Gegensatz zum Verbindungssteg über eine hohe Steifigkeit und ist schlecht umformbar. Dadurch wird eine Verformung des Anschlusselements bei Umbiegen des Verbindungsstegs vermieden. Besonders bei brückenförmigen Anschlusselementen tritt bei Umformung des Verbindungsstegs eine Torsion des Brückenbereichs ein, die auch zu einer Beschädigung der Lötverbindung zwischen Anschlusselement und elektrisch leitfähiger Struktur führt. Eine derartige Verformung des Anschlusselements kann einerseits über die Wahl einer geeigneten Geometrie und andererseits durch die Verwendung eines schlecht umformbaren Werkstoffs vermieden werden. In einer bevorzugten Ausführungsform weist das Material des Anschlusselements bei 20°C ein Elastizitätsmodul auf von größer oder gleich 150 kN/mm², besonders bevorzugt von größer oder gleich 190 kN/mm².

Das erfindungsgemäße Anschlusselement umfasst Titan, Eisen, Nickel, Kobalt, Molybdän, Kupfer, Zink, Zinn, Mangan, Niob und/oder Chrom und/oder Legierungen davon.

Bevorzugt enthält das Anschlusselement einen chromhaltigen Stahl mit einem Anteil an Chrom von größer oder gleich 10,5 Gew.-%. Weitere Legierungsbestandteile wie Molybdän, Mangan oder Niob führen zu einer verbesserten Korrosionsbeständigkeit oder veränderten mechanischen Eigenschaften, wie Zugfestigkeit oder Kaltumformbarkeit.

Das erfindungsgemäße Anschlusselement enthält bevorzugt zumindest 66,5 Gew.-% bis 89,5 Gew.-% Eisen, 10,5 Gew.-% bis 20 Gew.-% Chrom, 0 Gew.-% bis 1 Gew.-% Kohlenstoff, 0 Gew.-% bis 5 Gew.-% Nickel, 0 Gew.-% bis 2 Gew.-% Mangan, 0 Gew.-% bis 2,5 Gew.-% Molybdän, 0 Gew.-% bis 2 Gew.-% Niob und 0 Gew.-% bis 1 Gew.-% Titan. Das Anschlusselement kann zusätzlich Beimengungen weiterer Elemente enthalten, darunter Vanadium, Aluminium und Stickstoff.

Das Anschlusselement enthält besonders bevorzugt zumindest 73 Gew.-% bis 89,5 Gew.-% Eisen, 10,5 Gew.-% bis 20 Gew.-% Chrom, 0 Gew.-% bis 0,5 Gew.-% Kohlenstoff, 0 Gew.-% bis 2,5 Gew.-% Nickel, 0 Gew.-% bis 1 Gew.-% Mangan, 0 Gew.-% bis 1,5 Gew.-% Molybdän, 0 Gew.-% bis 1 Gew.-% Niob und 0 Gew.-% bis 1 Gew.-% Titan. Das Anschlusselement kann zusätzlich Beimengungen weiterer Elemente enthalten, darunter Vanadium, Aluminium und Stickstoff.

Das Anschlusselement enthält ganz besonders bevorzugt zumindest 77 Gew.-% bis 84 Gew.-% Eisen, 16 Gew.-% bis 18,5 Gew.-% Chrom, 0 Gew.-% bis 0,1 Gew.-% Kohlenstoff, 0 Gew.-% bis 1 Gew.-% Mangan, 0 Gew.-% bis 1 Gew.-% Niob, 0 Gew.-% bis 1,5 Gew.-% Molybdän und 0 Gew.-% bis 1 Gew.-% Titan. Das Anschlusselement kann zusätzlich Beimengungen weiterer Elemente enthalten, darunter Vanadium, Aluminium und Stickstoff.

Chromhaltiger, insbesondere sogenannter rostfreier oder nichtrostender Stahl ist kostengünstig verfügbar. Anschlusselemente aus chromhaltigem Stahl weisen zudem im Vergleich zu vielen herkömmlichen Anschlusselementen, beispielsweise aus Kupfer, eine hohe Steifigkeit auf, was zu einer vorteilhaften Stabilität des Anschlusselements führt. Besonders bei den bevorzugten brückenförmigen Anschlusselementen kann dadurch eine Torsion des Anschlusselements bei der Umformung des Verbindungsstegs vermieden werden. Zudem weist chromhaltiger Stahl im Vergleich zu vielen herkömmlichen Anschlusselementen, beispielsweise solchen aus Titan, eine verbesserte Lötbarkeit auf, die sich aus einer höheren Wärmeleitfähigkeit ergibt.

Besonders geeignete chromhaltige Stähle sind Stähle der Werkstoffnummern 1.4016, 1.4113, 1.4509 und 1.4510 nach EN 10 088-2.

Die Materialstärke des Anschlusselements beträgt bevorzugt 0,1 mm bis 2 mm, besonders bevorzugt 0,2 mm bis 1 mm, ganz besonders bevorzugt 0,3 mm und 0,5 mm. In einer bevorzugten Ausführungsform ist die Materialstärke des Anschlusselements in seinem gesamten Bereich konstant. Dies ist besonders vorteilhaft im Hinblick auf eine einfache Herstellung des Anschlusselements.

Der Verbindungssteg umfasst Kupfer oder kupferhaltige Legierungen. Des Weiteren können Titan, Eisen, Nickel, Kobalt, Molybdän, Zink, Zinn, Mangan, Niob, Silicium und/oder Chrom und/oder Legierungen davon enthalten sein. Eine geeignete Materialzusammensetzung wird dabei nach ihrem elektrischen Widerstand ausgewählt.

In einer bevorzugten Ausführungsform umfasst der Verbindungssteg 45,0 Gew.-% bis 99,9 Gew.-% Kupfer, 0 Gew.-% bis 45 Gew.-% Zink, 0 Gew.-% bis 15 Gew.-% Zinn, 0 Gew.-% bis 30 Gew.-% Nickel und 0 Gew.-% bis 5 Gew.-% Silicium. Neben elektrolytischem Kupfer sind die verschiedensten Messing- oder Bronze-Legierungen als Materialien geeignet, beispielsweise Neusilber oder Konstantan.

Besonders bevorzugt enthält der Verbindungssteg 58 Gew.-% bis 99,9 Gew.-% Kupfer und 0 Gew.-% bis 37,0 Gew.-% Zink, insbesondere 60 Gew.-% bis 80 Gew.-% Kupfer und 20 Gew.-% bis 40 Gew.-% Zink.

Als besonderes Beispiel für das Material des Verbindungsstegs ist elektrolytisches Kupfer mit der Werkstoffnummer CW004A (ehemals 2.0065) und CuZn30 mit der Werkstoffnummer CW505L (ehemals 2.0265) zu nennen.

Der Verbindungssteg ist bevorzugt im brückenförmig ausgeprägten Teil des Anschlusselements angebracht, der keinen direkten Flächenkontakt zur elektrisch leitfähigen Struktur aufweist. Die Aufgabe des Verbindungsstegs ist es dabei einen Anschluss des Anschlusselements an die Bordelektronik eines Fahrzeugs zu ermöglichen. Der Stromfluss verläuft dabei über die Füße des Anschlusselements zum mittleren Teil des Anschlusselements, auf dem der Verbindungssteg angeordnet ist, hin zum Verbindungssteg. Der zentral angebrachte Verbindungssteg stellt somit einen Knotenpunkt dar an dem sich verschiedene Teilströme addieren. Aufgrund dessen ist ein niedriger elektrischer Widerstand des Verbindungsstegs von besonderer Bedeutung um an diesem Knotenpunkt eine möglichst hohe Leitfähigkeit und somit einen möglichst niedrigen Spannungsabfall zu erreichen.

Der Verbindungssteg kann in den verschiedensten Geometrien ausgeformt sein und verfügt bevorzugt über eine längliche Formgebung. Dabei sind sowohl runde als auch flache Ausführungsformen denkbar. Bevorzugt werden quaderförmige längliche Verbindungsstege verwendet, die eine ebene Fläche zur optimalen Anbringung des Verbindungsstegs auf dem Anschlusselement ermöglichen. Die Breite eines solchen quaderförmigen Verbindungsstegs beträgt 2 mm bis 8 mm, bevorzugt 4 mm bis 7 mm, besonders bevorzugt 4,5 mm bis 6,5 mm, während seine Höhe 0,2 mm bis 2 mm, bevorzugt 0,5 mm bis 1,5 mm, besonders bevorzugt 0,7 mm bis 0,9 mm misst. Die Länge des Verbindungssteges ist weitestgehend variabel. Die minimale Länge des Verbindungsstegs hängt von der Kontaktierung ab, die gewählt wird um den Verbindungssteg elektrisch leitfähig an eine Spannungsquelle anzuschließen. Eine Steckverbindung, die auf das freie Ende des Verbindungsstegs aufgeschoben wird weist demnach einen größeren Platzbedarf auf als beispielsweise ein Kabel, das direkt auf den Verbindungssteg aufgelötet wird. Der Verbindungssteg wird vorzugsweise umgeformt, so dass dessen freies Ende nicht mehr parallel zum Substrat verläuft und von diesem weg weist. Demnach muss der Verbindungssteg hinreichend lang sein, dass diese Umformung bewerkstelligt werden kann. Typischerweise werden Verbindungsstege mit einer Länge von 10 mm bis 150 mm, bevorzugt 20 mm bis 80 mm eingesetzt.

In einer bevorzugten Ausführungsform ist der Verbindungssteg so bemessen, dass normierte Kraftfahrzeugflachstecker mit einer Höhe von 0,8 mm und einer Breite von entweder 4,8 mm, 6,3 mm oder 9,5 mm auf das freie Ende des Verbindungsstegs aufgesteckt werden können. Die Ausführungsform des Verbindungsstegs mit einer Breite von 6,3 mm wird besonders bevorzugt eingesetzt, da dies den in diesem Bereich üblicherweise verwendeten Kraftfahrzeugflachsteckern nach DIN 46244 entspricht. Durch eine Normierung des Verbindungsstegs passend zur Größe der gängigen Kraftfahrzeugflachstecker ergibt sich eine einfache und auch reversible Möglichkeit die leitfähige Struktur des Substrats mit der Bordspannung zu verbinden. Bei einem Kabelbruch des Anschlusskabels muss somit zum Austausch des defekten Teils keine Lötverbindung erneuert werden, sondern das Ersatzkabel wird nur auf den Verbindungssteg aufgesteckt. Alternativ kann die elektrische Kontaktierung des Verbindungsstegs jedoch auch über eine Lötverbindung oder eine Crimpverbindung erfolgen.

Verwendbare Anschlusskabel zur Kontaktierung des Verbindungsstegs sind prinzipiell alle Kabel, die dem Fachmann zur elektrischen Kontaktierung einer elektrisch leitfähigen Struktur bekannt sind. Das Anschlusskabel kann neben einem elektrisch leitfähigen Kern (Innenleiter) eine isolierende, bevorzugt polymere Ummantelung umfassen, wobei die isolierende Ummantelung bevorzugt im Endbereich des Anschlusskabels entfernt ist, um eine elektrisch leitende Verbindung zwischen Anschlusselement und Innenleiter zu ermöglichen.

Der elektrisch leitfähige Kern des Anschlusskabels kann beispielsweise Kupfer, Aluminium und/oder Silber oder Legierungen oder Gemische davon enthalten. Der elektrisch leitfähige Kern kann beispielsweise als Drahtlitzenleiter oder als Volldrahtleiter ausgeführt sein. Der Querschnitt des elektrisch leitfähigen Kerns des Anschlusskabels richtet sich nach der für die Verwendung der erfindungsgemäßen Scheibe erforderlichen Stromtragfähigkeit und kann vom Fachmann geeignet gewählt werden. Der Querschnitt beträgt beispielsweise von 0,3 mm² bis 6 mm².

Der Verbindungssteg ist elektrisch leitfähig mit dem Anschlusselement verbunden, wobei die Elemente mittels verschiedener Löt- oder Schweißtechniken verbunden werden können. Bevorzugt werden der Verbindungssteg und das Anschlusselement mittels Elektrodenwiderstandsschweißen, Ultraschallschweißen oder Reibschweißen verbunden.

In mindestens einem Teilbereich der Scheibe ist eine elektrisch leitfähige Struktur aufgebracht, die bevorzugt Silber, besonders bevorzugt Silberpartikel und Glasfritten, enthält. Die erfindungsgemäße elektrisch leitfähige Struktur weist bevorzugt eine Schichtdicke von 3 µm bis 40 µm, besonders bevorzugt von 5 µm bis 20 µm, ganz besonders bevorzugt von 7 µm bis 15 µm und insbesondere von 8 µm bis 12 µm auf. Das Anschlusselement ist über eine Kontaktfläche vollflächig mit einem Teilbereich der elektrisch leitfähigen Struktur verbunden. Die elektrische Kontaktierung erfolgt dabei mittels der bleifreien Lotmasse. Die elektrisch leitfähige Struktur kann beispielsweise der Kontaktierung von auf der Scheibe angebrachten Drähten oder einer Beschichtung dienen. Dabei ist die elektrisch leitfähige Struktur beispielsweise in Form von Sammelleitern an gegenüberliegenden Rändern der Scheibe angebracht. Über die auf den Sammelleitern angebrachten Anschlusselemente kann eine Spannung angelegt werden, wodurch ein Strom durch die leitfähigen Drähte bzw. die Beschichtung von einem Sammelleiter zum anderen fließt und die Scheibe erwärmt. Alternativ zu einer solchen Heizfunktion ist die erfindungsgemäße Scheibe auch in Kombination mit Antennenleitern verwendbar oder auch in beliebigen anderen Ausgestaltungen, bei denen eine stabile Kontaktierung der Scheibe benötigt wird, denkbar.

Das Substrat enthält bevorzugt Glas, besonders bevorzugt Flachglas, Floatglas, Quarzglas, Borosilikatglas und/oder Kalk-Natron-Glas. Das Substrat kann aber auch Polymere enthalten, bevorzugt Polyethylen, Polypropylen, Polycarbonat, Polymethylmethacrylat, Polystyrol, Polybutadien, Polynitrile, Polyester, Polyurethan, Polyvinylchlorid, Polyacrylat, Polyamid, Polyethylenterephthalat und/oder Copolymere oder Gemische davon. Das Substrat ist bevorzugt transparent. Das Substrat weist bevorzugt eine Dicke von 0,5 mm bis 25 mm, besonders bevorzugt von 1 mm bis 10 mm und ganz besonders bevorzugt von 1,5 mm bis 5 mm auf.

Der thermische Ausdehnungskoeffizient des Substrats beträgt bevorzugt 8 x 10⁻⁶/°C bis 9 x 10⁻⁶/°C. Das Substrat enthält bevorzugt Glas, das bevorzugt einen thermischen Ausdehnungskoeffizienten von 8,3 x 10⁻⁶/°C bis 9 x 10⁻⁶/°C in einem Temperaturbereich von 0 °C bis 300 °C aufweist.

Die elektrisch leitfähige Struktur ist mit dem Anschlusselement elektrisch leitend über die bleifreie Lotmasse verbunden. Die bleifreie Lotmasse ist dabei an den Kontaktflächen angeordnet, die sich an der Unterseite des Anschlusselements befinden.

Die Schichtdicke der bleifreien Lotmasse beträgt bevorzugt kleiner oder gleich 600 µm, besonders bevorzugt zwischen 150 µm und 600 µm, insbesondere kleiner 300 µm.

Die bleifreie Lotmasse ist bevorzugt bleifrei. Dies ist besonders vorteilhaft im Hinblick auf die Umweltverträglichkeit der erfindungsgemäßen Scheibe mit elektrischem Anschlusselement. Als bleifreie Lotmasse ist im Sinne der Erfindung eine Lotmasse zu verstehen, welche entsprechend der EG-Richtlinie "2002/95/EG zur Beschränkung der Verwendung bestimmter gefährlicher Stoffe in Elektro- und Elektronikgeräten" einen Anteil von kleiner oder gleich 0,1 Gew.-% Blei, bevorzugt kein Blei enthält.

Bleifreie Lotmassen weisen typischerweise eine geringere Duktilität auf als bleihaltige Lotmassen, so dass mechanische Spannungen zwischen Anschlusselement und Scheibe weniger gut kompensiert werden können. Es hat sich aber gezeigt, dass kritische mechanische Spannungen durch das erfindungsgemäße Anschlusselement vermieden werden können. Die Lotmasse enthält bevorzugt Zinn und Bismut, Indium, Zink, Kupfer, Silber oder Zusammensetzungen davon. Der Anteil an Zinn in der erfindungsgemäßen Lotzusammensetzung beträgt 3 Gew.-% bis 99,5 Gew.-%, bevorzugt 10 Gew.-% bis 95,5 Gew.-%, besonders bevorzugt 15 Gew.-% bis 60 Gew.-%. Der Anteil an Bismut, Indium, Zink, Kupfer, Silber oder Zusammensetzungen davon beträgt in der erfindungsgemäßen Lotzusammensetzung 0,5 Gew.-% bis 97 Gew.-%, bevorzugt 10 Gew.-% bis 67 Gew.-%, wobei der Anteil an Bismut, Indium, Zink, Kupfer oder Silber 0 Gew.-% betragen kann. Die Lotzusammensetzung kann Nickel, Germanium, Aluminium oder Phosphor mit einem Anteil von 0 Gew.-% bis 5 Gew.-% enthalten. Die erfindungsgemäße Lotzusammensetzung enthält ganz besonders bevorzugt Bi40Sn57Ag3, Sn40Bi57Ag3, Bi59Sn40Agl, Bi57Sn42Agl, In97Ag3, In60Sn36,5Ag2Cu1,5, Sn95,5Ag3,8Cu0,7, Bi67In33, Bi33In50Sn17, Sn77,2In20Ag2,8, Sn95Ag4Cul, Sn99Cul, Sn96,5Ag3,5, Sn96,5Ag3Cu0,5, Sn97Ag3 oder Gemische davon.

In einer vorteilhaften Ausgestaltung enthält die Lotmasse Bismut. Es hat sich gezeigt, dass eine Bismut-haltige Lotmasse zu einer besonders guten Haftung des erfindungsgemäßen Anschlusselements an der Scheibe führt, wobei Beschädigungen der Scheibe vermieden werden können. Der Anteil des Bismuts an der Lotmassenzusammensetzung beträgt bevorzugt von 0,5 Gew.-% bis 97 Gew.-%, besonders bevorzugt von 10 Gew.-% bis 67 Gew.-% und ganz besonders bevorzugt von 33 Gew.-% bis 67 Gew.-%, insbesondere von 50 Gew.-% bis 60 Gew.-%. Die Lotmasse enthält neben Bismut bevorzugt Zinn und Silber oder Zinn, Silber und Kupfer. In einer besonders bevorzugten Ausgestaltung enthält die Lotmasse zumindest 35 Gew.-% bis 69 Gew.-% Bismut, 30 Gew.-% bis 50 Gew.-% Zinn, 1 Gew.-% bis 10 Gew.-% Silber und 0 Gew.-% bis 5 Gew.-% Kupfer. In einer ganz besonders bevorzugten Ausgestaltung enthält die Lotmasse zumindest 49 Gew.-% bis 60 Gew.-% Bismut, 39 Gew.-% bis 42 Gew.-% Zinn, 1 Gew.-% bis 4 Gew.-% Silber und 0 Gew.-% bis 3 Gew.-% Kupfer.

In einer weiteren vorteilhaften Ausgestaltung enthält die Lotmasse von 90 Gew.-% bis 99,5 Gew.-% Zinn, bevorzugt von 95 Gew.-% bis 99 Gew.-%, besonders bevorzugt von 93 Gew.-% bis 98 Gew.-%. Die Lotmasse enthält neben Zinn bevorzugt von 0,5 Gew.-% bis 5 Gew.-% Silber und von 0 Gew.-% bis 5 Gew.-% Kupfer.

Die Lotmasse tritt mit einer Austrittsbreite von bevorzugt kleiner 1 mm aus dem Zwischenraum zwischen dem Lötbereich des Anschlusselements und der elektrisch leitfähigen Struktur aus. In einer bevorzugten Ausgestaltung ist die maximale Austrittsbreite kleiner 0,5 mm und insbesondere etwa 0 mm. Das ist besonders vorteilhaft im Hinblick auf die Reduzierung von mechanischen Spannungen in der Scheibe, die Haftung des Anschlusselements und die Einsparung des Lots. Die maximale Austrittsbreite ist definiert als der Abstand zwischen den Außenkanten des Lötbereichs und der Stelle des Lotmasseübertritts, an dem die Lotmasse eine Schichtdicke von 50 µm unterschreitet. Die maximale Austrittsbreite wird nach dem Lötvorgang an der erstarrten Lotmasse gemessen. Eine gewünschte maximale Austrittsbreite wird durch eine geeignete Wahl von Lotmassenvolumen und lotrechtem Abstand zwischen Anschlusselement und elektrisch leitfähiger Struktur erreicht, was durch einfache Versuche ermittelt werden kann. Der lotrechte Abstand zwischen Anschlusselement und elektrisch leitfähiger Struktur kann durch ein entsprechendes Prozesswerkzeug, beispielsweise ein Werkzeug mit einem integrierten Abstandshalter, vorgegeben werden. Die maximale Austrittsbreite kann auch negativ sein, also in den vom Lötbereich des elektrischen Anschlusselements und elektrisch leitfähiger Struktur gebildeten Zwischenraum zurückgezogen sein. In einer vorteilhaften Ausgestaltung der erfindungsgemäßen Scheibe ist die maximale Austrittsbreite in dem vom Lötbereich des elektrischen Anschlusselements und der elektrisch leitfähigen Struktur gebildeten Zwischenraum in einem konkaven Meniskus zurückgezogen. Ein konkaver Meniskus entsteht beispielsweise durch Erhöhen des lotrechten Abstands zwischen Abstandshalter und leitfähiger Struktur beim Lötvorgang, während das Lot noch flüssig ist. Der Vorteil liegt in der Reduzierung der mechanischen Spannungen in der Scheibe, insbesondere im kritischen Bereich, der bei einem großen Lotmasseübertritt vorliegt.

In einer vorteilhaften Ausgestaltung der Erfindung weist die Kontaktfläche des Anschlusselements Abstandshalter auf, bevorzugt mindestens zwei Abstandshalter, besonders bevorzugt mindestens drei Abstandshalter. Die Abstandshalter sind bevorzugt einstückig mit dem Anschlusselement ausgebildet, beispielsweise durch Prägen oder Tiefziehen. Die Abstandshalter haben bevorzugt eine Breite von 0,5 x 10⁻⁴ m bis 10 x 10⁻⁴ m und eine Höhe von 0,5 x 10⁻⁴ m bis 5 x 10⁻⁴ m, besonders bevorzugt von 1 x 10⁻⁴ m bis 3 x 10⁻⁴ m. Durch die Abstandshalter wird eine homogene, gleichmäßig dicke und gleichmäßig aufgeschmolzene Schicht der Lotmasse erreicht. Dadurch können mechanische Spannungen zwischen Anschlusselement und Scheibe verringert werden und die Haftung des Anschlusselements verbessert werden. Das ist insbesondere bei der Verwendung bleifreier Lotmassen besonders vorteilhaft, die aufgrund ihrer geringeren Duktilität im Vergleich zu bleihaltigen Lotmassen mechanische Spannungen weniger gut kompensieren können.

In einer vorteilhaften Ausgestaltung der Erfindung ist auf der vom Substrat abgewandten Oberfläche des Anschlusselements gegenüberliegend zu den Kontaktflächen zumindest eine Kontakterhebung angeordnet, welche der Kontaktierung des Anschlusselements mit dem Lötwerkzeug während des Lötvorgangs dient. Die Kontakterhebung ist bevorzugt zumindest im Bereich der Kontaktierung mit dem Lötwerkzeug konvex gekrümmt ausgeformt. Die Kontakterhebung hat bevorzugt eine Höhe von 0,1 mm bis 2 mm, besonders bevorzugt von 0,2 mm bis 1 mm. Die Länge und Breite der Kontakterhebung beträgt bevorzugt zwischen 0,1 und 5 mm, ganz besonders bevorzugt zwischen 0,4 mm und 3 mm. Die Kontakterhebungen sind bevorzugt einstückig mit dem Anschlusselement ausgebildet, beispielsweise durch Prägen oder Tiefziehen. Zum Löten können Elektroden verwendet werden, deren Kontaktseite flach ausgeformt ist. Die Elektrodenfläche wird mit der Kontakterhebung in Kontakt gebracht. Die Elektrodenfläche ist dabei parallel zur Oberfläche des Substrats angeordnet. Der Kontaktbereich zwischen Elektrodenfläche und Kontakterhebung bildet die Lötstelle. Die Position der Lötstelle wird dabei durch den Punkt auf der konvexen Oberfläche der Kontakterhebung bestimmt, der den größten lotrechten Abstand zur Oberfläche des Substrats aufweist. Die Position der Lötstelle ist unabhängig von der Position der Lötelektrode auf dem Anschlusselement. Das ist besonders vorteilhaft im Hinblick auf eine reproduzierbare, gleichmäßige Wärmeverteilung während des Lötvorgangs. Die Wärmeverteilung während des Lötvorgangs wird durch die Position, die Größe, die Anordnung und die Geometrie der Kontakterhebung bestimmt.

Das elektrische Anschlusselement weist bevorzugt zumindest auf der zur Lotmasse ausgerichteten Kontaktfläche eine Beschichtung (Benetzungsschicht) auf, die Nickel, Kupfer, Zink, Zinn, Silber, Gold oder Legierungen oder Schichten davon, bevorzugt Silber enthält. Dadurch wird eine verbesserte Benetzung des Anschlusselements mit der Lotmasse und eine verbesserte Haftung des Anschlusselements erreicht.

Das erfindungsgemäße Anschlusselement ist bevorzugt mit Nickel, Zinn, Kupfer und/oder Silber beschichtet. Das erfindungsgemäße Anschlusselement ist besonders bevorzugt mit einer haftvermittelnden Schicht, bevorzugt aus Nickel und/oder Kupfer, und zusätzlich mit einer lötbaren Schicht, bevorzugt aus Silber, versehen. Das erfindungsgemäße Anschlusselement ist ganz besonders bevorzugt mit 0,1 µm bis 0,3 µm Nickel und/oder 3 µm bis 20 µm Silber beschichtet. Das Anschlusselement kann vernickelt, verzinnt, verkupfert und/oder versilbert werden. Nickel und Silber verbessern die Stromtragfähigkeit und Korrosionsstabilität des Anschlusselements und die Benetzung mit der Lotmasse.

Der Verbindungssteg kann optional ebenfalls über eine Beschichtung verfügen. Eine Beschichtung des Verbindungsstegs ist jedoch nicht notwendig, da kein direkter Kontakt zwischen Verbindungssteg und Lotmasse besteht. Somit bedarf es keiner Optimierung der Benetzungseigenschaften des Verbindungsstegs. Dadurch werden die Produktionskosten der erfindungsgemäßen Scheibe mit Anschlusselement und Verbindungssteg gesenkt, da auf eine Beschichtung des Verbindungsstegs verzichtet werden kann und nur das Anschlusselement beschichtet wird.

In einer alternativen Ausführungsform weist der Verbindungssteg eine Beschichtung auf, die Nickel, Kupfer, Zink, Zinn, Silber, Gold oder Legierungen oder Schichten davon, bevorzugt Silber enthält. Bevorzugt ist der Verbindungssteg mit Nickel, Zinn, Kupfer und/oder Silber beschichtet. Ganz besonders bevorzugt ist der Verbindungssteg mit 0,1 µm bis 0,3 µm Nickel und/oder 3 µm bis 20 µm Silber beschichtet. Der Verbindungssteg kann vernickelt, verzinnt, verkupfert und/oder versilbert werden.

Die Form des elektrischen Anschlusselementes kann ein oder mehrere Lotdepots im Zwischenraum von Anschlusselement und elektrisch leitfähiger Struktur ausbilden. Die Lotdepots und Benetzungseigenschaften des Lotes am Anschlusselement verhindern den Austritt der Lotmasse aus dem Zwischenraum. Lotdepots können rechtwinklig, verrundet oder polygonal ausgestaltet sein.

Die Erfindung umfasst des Weiteren ein Verfahren zur Herstellung einer Scheibe mit zweiteiligem Anschlusselement mit Verbindungssteg enthaltend die nachfolgenden Schritte:
a) ein Verbindungssteg wird elektrisch leitfähig auf der Oberseite des Anschlusselements befestigt,
b) auf der Unterseite des Anschlusselements wird eine bleifreie Lotmasse auf mindestens einer Kontaktfläche aufgebracht,
c) das Anschlusselement wird mit der bleifreien Lotmasse auf einer elektrisch leitfähigen Struktur angeordnet und
d) das Anschlusselement mit der elektrisch leitfähigen Struktur verlötet wird.

Die elektrisch leitfähige Struktur kann durch an sich bekannte Verfahren auf das Substrat aufgebracht werden, beispielsweise durch Siebdruck-Verfahren. Das Aufbringen der elektrisch leitfähigen Struktur kann zeitlich vor, während oder nach den Verfahrensschritten (a) und (b) erfolgen.

Die Lotmasse wird bevorzugt als Plättchen oder abgeflachter Tropfen mit festgelegter Schichtdicke, Volumen, Form und Anordnung auf dem Anschlusselement angebracht. Die Schichtdicke des Lotmasseplättchens beträgt bevorzugt kleiner oder gleich 0,6 mm. Die Form des Lotmasseplättchens entspricht bevorzugt der Form der Kontaktfläche. Ist die Kontaktfläche beispielsweise rechteckig ausgebildet, so weist das Lotmasseplättchen bevorzugt eine rechteckige Form auf.

Das Einbringen der Energie beim elektrischen Verbinden von elektrischem Anschlusselement und elektrisch leitfähiger Struktur erfolgt bevorzugt mit Stempel, Thermoden, Kolbenlöten, Microflammlöten, bevorzugt Laserlöten, Heißluftlöten, Induktionslöten, Widerstandslöten und/oder mit Ultraschall.

Bevorzugt wird der Verbindungssteg auf der Oberseite des Anschlusselements verschweißt oder verlötet. Besonders bevorzugt wird der Verbindungssteg durch Elektrodenwiderstandsschweißen, Ultraschallschweißen oder Reibschweißen auf dem Anschlusselement befestigt.

Im Anschluss an Verfahrensschritt (d) erfolgt optional eine Umformung des Verbindungsstegs. Da das freie Ende des Verbindungsstegs nach Montage der Scheibe in der Fahrzeugkarosserie nur schwer erreichbar ist, ermöglicht eine Umformung des Verbindungsstegs eine wesentlich bessere Zugänglichkeit der Stegposition. Des Weiteren ist durch dieses Umbiegen eine genau definierte Stegposition erhältlich. Nach Umformung weist das freie Ende des Verbindungsstegs vom Substrat weg. Der Winkel, den das freie Ende des Verbindungsstegs zur Substratoberfläche einnimmt, ist je nach Anforderung frei wählbar. Da der erfindungsgemäße Verbindungssteg leicht umformbar ist müssen nur geringe Kräfte zum Umbiegen des Verbindungsstegs aufgewandt werden. Da der Verbindungssteg aus einem massiven Material besteht und nicht biegeschlaff ist, erfolgt eine plastische Umformung und die Position des Verbindungsstegs ist genau definierbar. Die Umformung des erfindungsgemäßen Verbindungsstegs erfolgt rein manuell und werkzeugfrei. Bei den dabei auftretenden geringen Kräften wird eine Torsion des im Vergleich zum Verbindungssteg wesentlich steiferen Anschlusselements vermieden. Auf diese Weise wird ebenfalls einer damit einhergehenden Beschädigung der Lötstelle vorgebeugt.

Der Verbindungssteg wird nach Installation der Scheibe im Fahrzeug und eventueller Umformung mit einer Steckverbindung, einem Blech, einer Litze oder einem Geflecht, beispielsweise aus Kupfer, mit der Bordelektronik verbunden. Bevorzugt wird eine Steckverbindung gewählt, die einerseits eine dauerhafte Stabilität gewährleistet sowie ein Verrutschen des Kontakts verhindert und andererseits aber auch reversibel ist. Dadurch kann das Anschlusskabel zwischen Verbindungssteg und Bordelektronik bei Beschädigung in einfacher Art und Weise ausgetauscht werden. Die anderen genannten Kontaktierungsmöglichkeiten erfordern hingegen ein Verlöten oder Verschweißen des Kontakts.

Die Erfindung umfasst ferner die Verwendung der erfindungsgemäßen Scheibe mit elektrisch leitfähigen Strukturen in Fahrzeugen, Architekturverglasung oder Gebäudeverglasung, insbesondere in Kraftfahrzeugen, Schienenfahrzeugen, Flugzeugen oder Seefahrzeugen. Dabei dient ein Anschlusselement der Verbindung von elektrisch leitfähigen Strukturen der Scheibe, wie beispielsweise Heizleitern oder Antennenleitern, mit externen elektrischen Systemen, wie beispielsweise Verstärkern, Steuereinheiten oder Spannungsquellen. Die Erfindung umfasst insbesondere die Verwendung der erfindungsgemäßen Scheibe in Schienenfahrzeugen oder Kraftfahrzeugen, bevorzugt als Windschutzscheibe, Heckscheibe, Seitenscheibe und/oder Dachscheibe, insbesondere als beheizbare Scheibe oder als Scheibe mit Antennenfunktion.

Die Erfindung wird anhand einer Zeichnung und Ausführungsbeispielen näher erläutert. Die Zeichnung ist eine schematische Darstellung und nicht maßstabsgetreu. Die Zeichnung schränkt die Erfindung in keiner Weise ein. Es zeigen:
Figur 1 eine schematische perspektivische Ansicht einer erfindungsgemäßen Scheibe mit Anschlusselement und Verbindungssteg.
Figur 2 einen Querschnitt der Scheibe gemäß Figur 1 entlang der Querschnittslinie AA'.
Figur 3 eine Draufsicht der Scheibe gemäß Figur 1.
Figur 4 eine erfindungsgemäße Scheibe gemäß Figur 1 und 2 mit Anschlusselement und umgeformtem Verbindungssteg.
Figur 5a eine Draufsicht einer weiteren Ausgestaltung der erfindungsgemäßen Scheibe mit Anschlusselement und Verbindungssteg sowie zusätzlichen Kontakterhebungen und Abstandshaltern.
Figur 5b Querschnitt der Scheibe gemäß Figur 5a entlang der Querschnittslinie BB'.
Figur 6 ein Fließschema des erfindungsgemäßen Verfahrens zur Herstellung einer Scheibe mit Anschlusselement und Verbindungssteg.

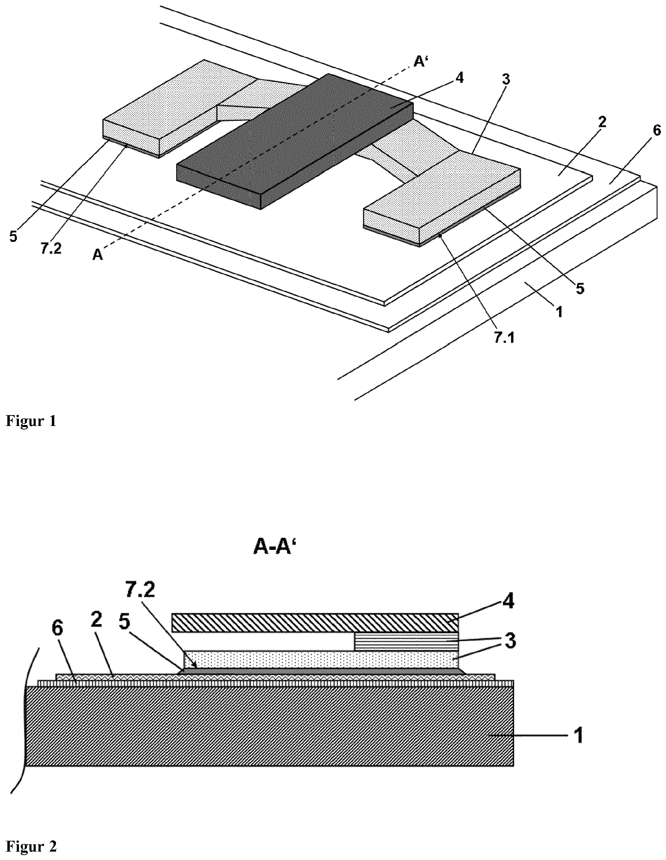

Figur 1 zeigt eine erfindungsgemäße Scheibe mit Anschlusselement (3) und Verbindungssteg (4). Auf einem Substrat (1) aus einem 3 mm dicken thermisch vorgespannten Einscheibensicherheitsglas aus Natron-Kalk-Glas ist ein Abdecksiebdruck (6) aufgebracht.

Das Substrat (1) weist eine Breite von 150 cm und eine Höhe von 80 cm auf, wobei an der kürzeren Seitenkante im Bereich des Abdecksiebdrucks (6) ein Anschlusselement (3) mit Verbindungssteg (4) angebracht ist. Auf der Oberfläche des Substrats (1) ist eine elektrisch leitfähige Struktur (2) in Form einer Heizleiterstruktur appliziert. Die elektrisch leitfähige Struktur enthält Silberpartikel und Glasfritten, wobei der Silberanteil größer als 90 % beträgt. Im Randbereich der Scheibe (I) ist die elektrisch leitfähige Struktur (2) auf 10 mm verbreitert. In diesem Bereich ist eine bleifreie Lotmasse (5) aufgebracht, die die elektrisch leitfähige Struktur (2) mit den Kontaktflächen (7) des Anschlusselements (3) verbindet. Die Kontaktierung wird nach der Montage in der Fahrzeugkarosserie durch den Abdecksiebdruck (6) verdeckt. Die bleifreie Lotmasse (5) stellt eine dauerhafte elektrische und mechanische Verbindung der elektrisch leitfähigen Struktur (2) mit dem Anschlusselement (3) sicher. Die bleifreie Lotmasse (5) enthält 57 Gew.-% Bismut, 42 Gew.-% Zinn und 1 Gew.-% Silber. Die bleifreie Lotmasse (5) hat eine Dicke von 250 µm. Das Anschlusselement (3) weist eine Brückenform auf. Das Anschlusselement umfasst zwei Füße mit je einer Kontaktfläche (7.1, 7.2) an deren Unterseite und einen brückenförmigen Abschnitt, der sich zwischen den Füßen erstreckt. Im brückenförmigen Abschnitt ist der Verbindungssteg (4) auf der Oberfläche des Anschlusselements (3) verschweißt. Der Verbindungssteg (4) ist bündig zu einer Außenkante des Anschlusselements (3) ausgerichtet und weist über die gegenüberliegende Außenkante in Richtung der Füße des Anschlusselements (3) hinaus, wobei Anschlusselement (3) und Verbindungssteg (4) zusammen eine E-förmige Anordnung ergeben. Das elektrische Anschlusselement (3) hat eine Breite von 4 mm und eine Länge von 24 mm und besteht aus Stahl der Werkstoff-Nummer 1.4509 nach EN 10 088-2 (ThyssenKrupp Nirosta® 4509) mit einem thermischen Ausdehnungskoeffizienten von 10,5 x 10⁻⁶/°C im Temperaturbereich von 20°C bis 300°C. Die Materialstärke des Anschlusselements (3) beträgt 0,8 mm. Der Verbindungssteg (4) weist eine Höhe von 0,8 mm, eine Breite von 6,3 mm und eine Länge von 27 mm auf. Der Verbindungssteg (4) besteht aus Kupfer der Werkstoffnummer CW004A (Cu-ETP) mit einem elektrischen Widerstand von 1,8 µOhm·cm.

Figur 2 einen Querschnitt der Scheibe gemäß Figur 1 entlang der Querschnittslinie AA'. Auf dem Substrat (1) ist der Abdecksiebdruck (6) angebracht auf dem sich die elektrisch leitfähige Struktur (2) befindet. Der brückenförmige Abschnitt des Anschlusselements (3), der von der Schnittlinie AA' geschnitten wird, ist schraffiert dargestellt, während der Fuß des Anschlusselements (3) gepunktet dargestellt ist. Auf dem brückenförmigen Abschnitt des Anschlusselements (3) liegt der Verbindungssteg (4) auf und ist dort verschweißt. An der Unterseite des Anschlusselements (3) befindet sich die zweite Kontaktfläche (7.2), an der der Fuß des Anschlusselements (3) die elektrisch leitfähige Struktur (2) kontaktiert. Zur elektrisch leitfähigen und mechanisch stabilen Verbindung des Anschlusselements und der elektrisch leitfähigen Struktur ist auf der zweiten Kontaktfläche (7.2) die bleifreie Lotmasse (5) angebracht. Die bleifreie Lotmasse (5) tritt mit einem konkaven Meniskus aus dem Spalt zwischen Anschlusselement (3) und elektrisch leitfähiger Struktur (2) aus. Der nicht gezeigte Teil des Anschlusselements (3) mit der ersten Kontaktfläche (7.1) ist analog zum hier beschriebenen Teil des Anschlusselements (3) aufgebaut.

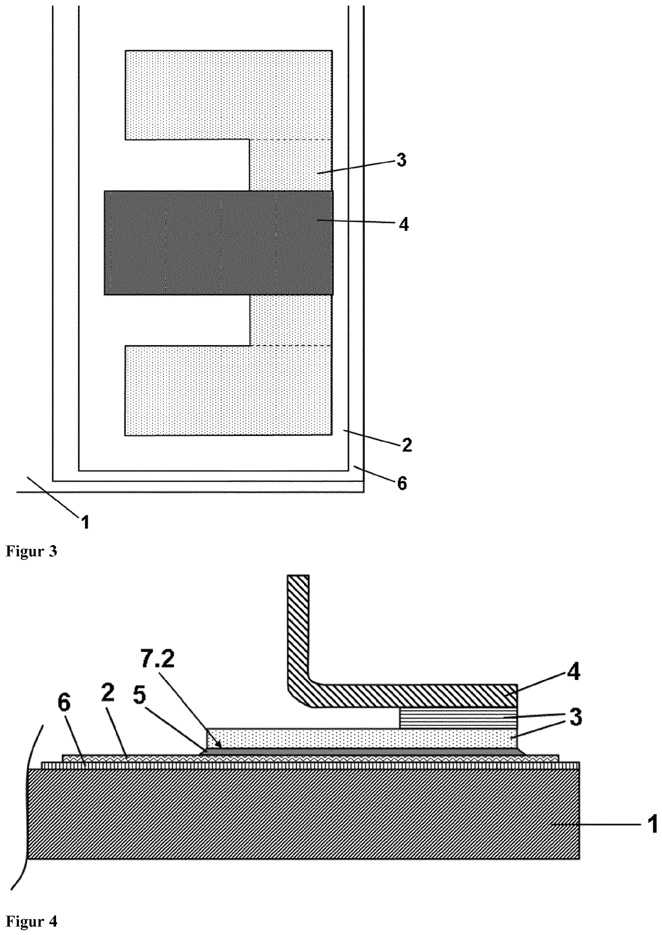

Figur 3 zeigt eine Draufsicht der Scheibe gemäß Figur 1. Das Anschlusselement (3) und der Verbindungssteg (4) bilden gemeinsam eine E-förmige Anordnung, wobei der Verbindungssteg (4) zwischen den Füßen des Anschlusselements (3) parallel zu diesen verläuft und in die gleiche Richtung weist.

Figur 4 zeigt eine erfindungsgemäße Scheibe gemäß Figur 1 und 2 mit Anschlusselement (3) und umgeformtem Verbindungssteg (4) entlang der Querschnittslinie AA'. Der generelle Aufbau der gezeigten erfindungsgemäßen Scheibe entspricht dem in den Figuren 1 und 2 beschriebenen, wobei der Verbindungssteg (4) vom Substrat (1) weg nach oben gebogen ist. Das freie Ende des Verbindungsstegs (4), das nicht direkt mit dem Anschlusselement (3) verbunden ist, nimmt einen Winkel von 90° zu der Oberfläche des Substrats (1) ein und weist von diesem weg. Die Stegposition ist auf diese Weise auch im Einbauzustand wesentlich besser zugänglich und genau definiert.

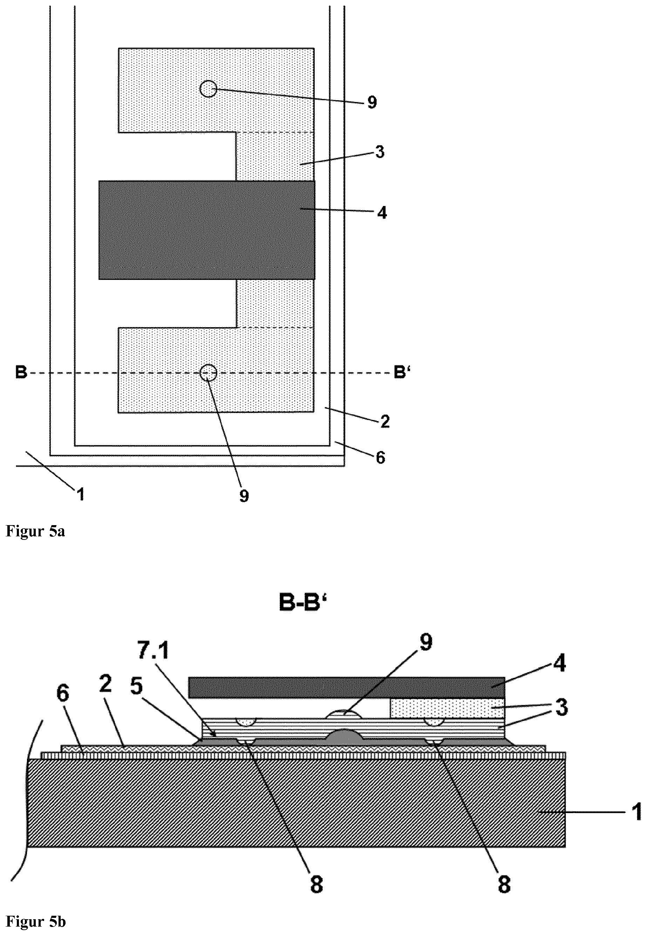

Figuren 5a und 5b zeigen eine weitere Ausgestaltung der erfindungsgemäßen Scheibe mit Anschlusselement (3) und Verbindungssteg (4) sowie zusätzlichen Abstandshaltern (8) und Kontakterhebungen (9). Die Abstandshalter (8) sind in der in Figur 5a gezeigten Draufsicht durch das Anschlusselement (3) verdeckt. Figur 5b zeigt einen Querschnitt durch einen Fuß des Anschlusselements (3) entlang der Schnittlinie BB'. Die geschnittenen Flächen des Anschlusselements werden dabei schraffiert dargestellt. Die in Figur 5b gezeigte Ansicht lässt zwei Abstandshalter (8) an der ersten Kontaktfläche (7.1) des Anschlusselements (3) erkennen. Die zweite Kontaktfläche (7.2) weist zwei analog dazu angeordnete Abstandshalter (8) auf (hier nicht gezeigt). Die Abstandshalter (8) sind an den Kontaktflächen (7) in die Füße des Anschlusselements (3) eingeprägt und somit einstückig mit diesem ausgebildet. Die Abstandshalter (8) sind als Kugelsegmente ausgeformt und haben eine Höhe von 2,5 x 10⁻⁴ m und eine Breite von 5 x 10⁻⁴ m. Durch die Abstandshalter (8) wird die Ausbildung einer gleichmäßigen Schicht der bleifreien Lotmasse (5) begünstigt. Dies ist besonders vorteilhaft im Hinblick auf die Haftung des Anschlusselements (3). Die Kontakterhebungen (9) sind an der den Kontaktflächen (7) gegenüberliegenden, vom Substrat (1) abgewandten Oberfläche des Anschlusselements (3) angeordnet. Die Kontakterhebungen (9) sind in die Füße des Anschlusselements (3) eingeprägt und somit einstückig mit diesem ausgebildet. Die Kontakterhebungen (9) sind als Kugelsegment ausgeformt und haben eine Höhe von 2,5 x 10⁻⁴ m und eine Breite von 5 x 10⁻⁴ m. Die Kontakterhebungen (9) dienen der Kontaktierung des Anschlusselements (3) mit dem Lötwerkzeug während des Lötvorgangs. Durch die Kontakterhebungen (9) wird eine reproduzierbare und definierte Wärmeverteilung unabhängig von der exakten Positionierung des Lötwerkzeugs sichergestellt.

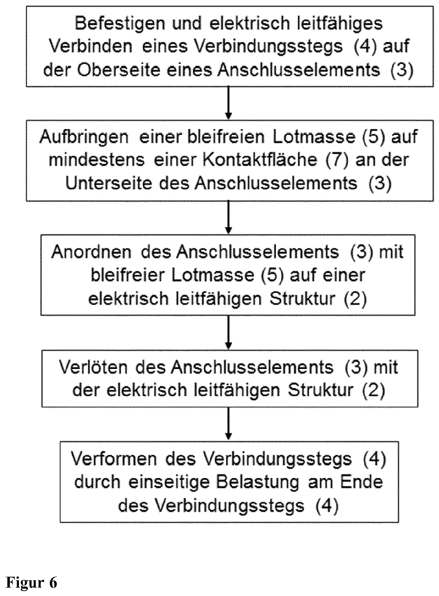

Figur 6 zeigt ein Fließschema des erfindungsgemäßen Verfahrens zur Herstellung einer Scheibe mit Anschlusselement (3) und Verbindungssteg (4). Zunächst wird ein Verbindungssteg (4) elektrisch leitfähig auf der Oberseite des Anschlusselements (3) aufgebracht. Danach wird eine bleifreie Lotmasse (5) auf der Unterseite des Anschlusselements (3) auf mindestens einer Kontaktfläche (7) aufgebracht und das Anschlusselement (3) mit der bleifreien Lotmasse (5) auf der elektrisch leitfähigen Struktur (2) angeordnet. Das Anschlusselement (3) wird daraufhin mit der elektrisch leitfähigen Struktur (2) verlötet. Bevorzugt wird der Verbindungssteg (4) anschließend durch einseitige Belastung am äußeren freien Ende des Verbindungsstegs (4) umgeformt um eine bessere Zugänglichkeit des Verbindungsstegs (4) zu gewährleisten. Die Umformung des Verbindungsstegs (4) kann direkt im Anschluss an die vorhergehenden Schritte erfolgen oder auch erst nach dem Einbau der Scheibe in die Fahrzeugkarosserie, bevorzugt nach Einbau der Scheibe.

Im Folgenden wird die Erfindung anhand einer Testreihe von Scheiben mit einteiligen Anschlusselementen nach dem Stand der Technik und der erfindungsgemäßen Scheibe mit zweiteiligem Anschlusselement und Verbindungssteg jeweils in Verbindung mit einer bleifreien Lotmasse verglichen.

Tabelle 1 zeigt eine kleine Auswahl verschiedener Werkstoffe, die in nach dem Stand der Technik bekannten Anschlusselementen und/oder im erfindungsgemäßen Anschlusselement verwendet werden können. Die in der letzten Spalte aufgeführten Verweise beziehen sich auf die Quellenangabe der angegebenen physikalischen Eigenschaften.

**Tabelle 1**

| **Werkstoff** | **Werkstoffnummer** | **E-Modul** (kN/mm²) | **elektr. Widerstand** (µOhm·cm) | **CTE** (·10⁻⁶/°C) | **Quelle** |
|---|---|---|---|---|---|
| Kupfer | CW004A | 130 | 1,8 | 16,8 | 1 |
| CuZn30 | CW505L | 115 | 6,2 | 19,0 | 1 |
| ThyssenKrupp Nirosta® 4016 | 1.4016 | 220 | 60 | 10,0 | 2 |
| ThyssenKrupp Nirosta® 4113 | 1.4113 | 220 | 60 | 10,0 | 2 |
| ThyssenKrupp Nirosta® 4509 | 1.4509 | 220 | 60 | 10,0 | 2 |
| ThyssenKrupp Nirosta® 4510 | 1.4510 | 220 | 60 | 10,0 | 2 |
| Titan | 3.7024 / 3.7025 | 105 | 4,7 | 8,9 | 2 |

| | | | | | |
|---|---|---|---|---|---|
| Quelle 1: Werkstoffdatenblätter Deutsches Kupferinstitut Quelle 2: Werkstoffdatenblätter ThyssenKrupp | | | | | |

In einer Versuchsreihe wurde ein erfindungsgemäßes Anschlusselement (3) mit Verbindungssteg (4) mit drei verschiedenen Anschlusselementen nach dem Stand der Technik verglichen. Um eine Vergleichbarkeit zu gewährleisten wurden sowohl das erfindungsgemäße zweiteilige Anschlusselement mit Verbindungssteg als auch die nach dem Stand der Technik bekannten einstückig ausgeformten Anschlusselemente mit Verbindungssteg in der gleichen Geometrie eingesetzt. Die Geometrie der Anschlusselemente entsprach dabei der in Figur 1 gezeigten Anordnung. Als Substrat (1) wurde ein 3 mm dickes thermisch vorgespanntes Einscheibensicherheitsglas aus Natron-Kalk-Glas mit einem Abdecksiebdruck (6) aufgebracht. Das Substrat (1) wies eine Breite von 150 cm und eine Höhe von 80 cm auf, wobei an der kürzeren Seitenkante im Bereich des Abdecksiebdrucks (6) ein Anschlusselement mit Verbindungssteg (4) angebracht wurde. Die jeweils verwendeten Anschlusselemente umfassten zwei Füße mit je einer Kontaktfläche (7.1, 7.2) an deren Unterseite. Auf der Oberfläche des Substrats (1) war eine elektrisch leitfähige Struktur (2) in Form einer Heizleiterstruktur appliziert. Die elektrisch leitfähige Struktur umfasste dabei Silberpartikel und Glasfritten, wobei der Silberanteil größer als 90 % gewählt wurde. Im Randbereich der Scheibe (I) war die elektrisch leitfähige Struktur (2) auf 10 mm verbreitert. Auf diesem Bereich waren jeweils die verschiedenen Anschlusselemente aufgebracht. Dazu diente eine bleifreie Lotmasse (5) aus 57 Gew.-% Bismut, 42 Gew.-% Zinn und 1 Gew.-% Silber, die mit einer Dicke von 250 µm zwischen den Kontaktflächen (7) des Anschlusselements und der elektrisch leitfähigen Struktur (2) angebracht war. Die im Beispiel und in den Vergleichsbeispielen verwendeten Anschlusselemente wiesen die gleiche Brückenform auf. Im brückenförmigen Abschnitt der Anschlusselemente befand sich jeweils ein Verbindungssteg auf der Oberfläche der Anschlusselemente. Der Verbindungssteg war dabei bündig zu einer Außenkante des Anschlusselements ausgerichtet und wies über die gegenüberliegende Außenkante in Richtung der Füße des Anschlusselements hinaus, wobei Anschlusselement und Verbindungssteg zusammen eine E-förmige Anordnung ergaben. Die verwendeten Anschlusselemente hatten eine Breite von 4 mm und eine Länge von 24 mm. Die Materialstärke der Anschlusselemente betrug 0,8 mm und der Verbindungsstege wiesen eine Höhe von 0,8 mm, eine Breite von 6,3 mm und eine Länge von 27 mm auf. In den Vergleichsbeispielen waren die Verbindungsstege einstückig mit den Anschlusselementen ausgeformt und bestanden somit auch aus dem gleichen Material. Im erfindungsgemäßen Beispiel war auf der Oberfläche des erfindungsgemäßen Anschlusselements (3) der Verbindungssteg (4) aufgeschweißt. Der Verbindungssteg (4) und das Anschlusselement (3) waren dabei zweiteilig ausgeformt und bestanden aus unterschiedlichen Materialien.

Tabelle 2 zeigt die im erfindungsgemäßen Beispiel und in den Vergleichsbeispielen verwendeten Materialien des Anschlusselements und des Verbindungsstegs sowie die einteilige oder zweiteilige Ausführung von Anschlusselement und Verbindungssteg.

**Tabelle 2**

| | **Material Anschlusselement** | **Material Verbindungssteg** | **Ausführung** |
|---|---|---|---|
| **Beispiel 1** | ThyssenKrupp Nirosta® 4509, Werkstoffnr. 1.4509 | Kupfer, Werkstoffnr. CW004A | zweiteilig |
| **Vergleichsbeispiel 2** | Kupfer, Werkstoffnr. CW004A | Kupfer, Werkstoffnr. CW004A | einteilig |
| **Vergleichsbeispiel 3** | ThyssenKrupp Nirosta® 4509, Werkstoffnr. 1.4509 | ThyssenKrupp Nirosta® 4509, Werkstoffnr. 1.4509 | einteilig |
| **Vergleichsbeispiel 4** | Titan, Werkstoffnr. 3.7024 | Titan, Werkstoffnr. 3.7024 | einteilig |

Die Proben aus Beispiel 1 und den Vergleichsbeispielen 2 bis 4 wurden anschließend den verschiedensten Prüfungen unterzogen. In einer ersten Testreihe wurden die Proben in einem Temperaturwechseltest hinsichtlich ihrer Stabilität überprüft, wobei diese einem Temperaturwechsel von +80 °C auf -30 °C unterzogen wurden. In einer zweiten Testreihe wurden die Verbindungsstege in einem Winkel von 90° nach oben vom Substrat (1) weg weisend gebogen, wie in Figur 4 gezeigt. Im Anschluss daran wurden die Proben hinsichtlich einer Beschädigung der Lötstelle und einer Torsion des Anschlusselements begutachtet. Des Weiteren werden die elektrischen Widerstände der jeweiligen Verbindungsstege verglichen. Diese bilden ein Maß für die Leitfähigkeit der Verbindungsstege, die möglichst hoch sein sollte. Tabelle 3 zeigt die Ergebnisse der Testreihen für Beispiel 1 sowie die Vergleichsbeispiele 2 bis 4.

**Tabelle 3**

| | **Temperaturwechseltest** | **Umformung Verbindungssteg** | **elektr. Widerstand Verbindungssteg** |
|---|---|---|---|
| **Beispiel 1** | keine Schäden | keine Schäden | 1,8 µOhm·cm |
| **Vergleichsbeispiel 2** | Beschädigung durch Glasabplatzung | Beschädigung der Lötstelle | 1,8 µOhm·cm |
| **Vergleichsbeispiel 3** | keine Schäden | keine Schäden | 60 µOhm·cm |
| **Vergleichsbeispiel 4** | keine Schäden | Beschädigung der Lötstelle | 4,7 µOhm·cm |

Wie in Tabelle 3 erkennbar traten nur in Beispiel 1 und Vergleichsbeispiel 3 im Temperaturwechseltest sowie bei der Umformung des Verbindungsstegs keinerlei Beschädigungen der Probe auf. In Vergleichsbeispiel 2 kam es in Temperaturwechseltests zu einer Beschädigung der Probe. Aufgrund der unterschiedlichen Ausdehnungskoeffizienten des Substrats und des Anschlusselements traten Abplatzungen des Glases im Bereich der Kontaktflächen des Anschlusselements auf. Ferner wurde in Vergleichsbeispiel 2 die Lötstelle bei der Umformung des Verbindungsstegs beschädigt. Da das Anschlusselement in Vergleichsbeispiel 2 aus leicht umformbarem Kupfer bestand trat beim Umbiegen des Verbindungsstegs eine Torsion des brückenförmigen Anschlusselements auf, die zu dieser Beschädigung führte. In Vergleichsbeispiel 4 traten in Temperaturwechseltests keine Beschädigungen der Probe auf, jedoch kam es aufgrund der zu geringen Steifigkeit des Anschlusselements zu Beschädigungen der Lötstelle während des Umformprozesses. Ferner ist zu erwähnen, dass der in Vergleichsbeispiel 4 verwendete Titan-Werkstoff teuer und nur schlecht verlötbar ist. Derartige Beschädigungen der Probe sind im Produktionsalltag nicht tolerierbar, so dass nur Beispiel 1 und Vergleichsbeispiel 3 eine hinreichende Stabilität aufweisen. In Vergleichsbeispiel 3 bestehen Abschlusselement und Verbindungssteg aus einem schlecht leitenden Stahl, wodurch im Vergleich zum erfindungsgemäßen Beispiel 1 ein wesentlich höherer Spannungsabfall am Verbindungssteg auftritt. Dieser sollte jedoch möglichst niedrig gehalten werden um einen optimalen Stromfluss zu gewährleisten. Somit stellt nur die erfindungsgemäße Lösung in Beispiel 1 ein Anschlusselement bereit, das über eine ausreichende Temperaturstabilität verfügt und einen beliebig umformbaren Verbindungssteg besitzt, an dem nur ein geringer Spannungsabfall auftritt. Diese Ergebnisse waren für den Fachmann überraschend und unerwartet.

### Bezugszeichenliste

- 1: transparentes Substrat
- 2: leitfähige Struktur
- 3: Anschlusselement
- 4: Verbindungssteg
- 5: bleifreie Lotmasse
- 6: Siebdruck
- 7: Kontaktflächen
- 7.1: erste Kontaktfläche
- 7.2: zweite Kontaktfläche
- 8: Abstandshalter
- 9: Kontakterhebungen
- AA': Querschnittslinie
- BB': Querschnittslinie

## Patentansprüche

1. Eine Scheibe mit mindestens einem Anschlusselement (3) mit Verbindungssteg (4) mindestens umfassend
- ein Substrat (1) mit elektrisch leitfähiger Struktur (2) auf mindestens einem Teilbereich des Substrats (1),
- mindestens ein elektrisches Anschlusselement (3) auf mindestens einem Teilbereich der elektrisch leitfähigen Struktur (2),
- ein Verbindungssteg (4) auf mindestens einem Teilbereich des Anschlusselements (3) und
- eine bleifreie Lotmasse (5), die das elektrische Anschlusselement (3) in mindestens einem Teilbereich mit der elektrisch leitfähigen Struktur (2) verbindet,
wobei die Differenz der thermischen Ausdehnungskoeffizienten des Substrats (1) und des Anschlusselements (3) kleiner 5 x 10⁻⁶/°C ist,
wobei der Verbindungssteg (4) massiv ausgeformt ist und Kupfer enthält und
wobei die Materialzusammensetzungen des Anschlusselements (3) und des Verbindungsstegs (4) sich unterscheiden.

2. Scheibe nach Anspruch 1, wobei der elektrische Widerstand des Verbindungsstegs (4) zwischen 0,5 µOhm·cm und 20 µOhm·cm, bevorzugt zwischen 1,0 µOhm·cm und 15 µOhm·cm, besonders bevorzugt zwischen 1,5 µOhm·cm und 11 µOhm·cm beträgt.

3. Scheibe nach Anspruch 1 oder 2, wobei das Anschlusselement (3) Titan, Eisen, Nickel, Kobalt, Molybdän, Kupfer, Zink, Zinn, Mangan, Niob und/oder Chrom und/oder Legierungen davon, bevorzugt Eisen-Legierungen enthält.

4. Scheibe nach Anspruch 3, wobei das Anschlusselement (3) zumindest 66,5 Gew.-% bis 89,5 Gew.-% Eisen, 10,5 Gew.-% bis 20 Gew.-% Chrom, 0 Gew.-% bis 1 Gew.-% Kohlenstoff, 0 Gew.-% bis 5 Gew.-% Nickel, 0 Gew.-% bis 2 Gew.-% Mangan, 0 Gew.-% bis 2,5 Gew.-% Molybdän, 0 Gew.-% bis 2 Gew.-% Niob und 0 Gew.-% bis 1 Gew.-% Titan enthält.

5. Scheibe nach Anspruch 4, wobei das Anschlusselement (3) zumindest 77 Gew.-% bis 84 Gew.-% Eisen, 16 Gew.-% bis 18,5 Gew.-% Chrom, 0 Gew.-% bis 0,1 Gew.-% Kohlenstoff, 0 Gew.-% bis 1 Gew.-% Mangan, 0 Gew.-% bis 1 Gew.-% Niob, 0 Gew.-% bis 1,5 Gew.-% Molybdän und 0 Gew.-% bis 1 Gew.-% Titan enthält.

6. Scheibe nach einem der Ansprüche 1 bis 5, wobei der Verbindungssteg (4) Titan, Eisen, Nickel, Kobalt, Molybdän, Zink, Zinn, Mangan, Niob, Silicium, Chrom und/oder Legierungen davon enthält.

7. Scheibe nach Anspruch 6, wobei der Verbindungssteg (4) 45,0 Gew.-% bis 99,9 Gew.-% Kupfer, 0 Gew.-% bis 45 Gew.-% Zink, 0 Gew.-% bis 15 Gew.-% Zinn, 0 Gew.-% bis 30 Gew.-% Nickel und 0 Gew.-% bis 5 Gew.-% Silicium enthält.

8. Scheibe nach Anspruch 7, wobei der Verbindungssteg (4) 58 Gew.-% bis 99,9 Gew.-% Kupfer und 0 Gew.-% bis 37,0 Gew.-% Zink, bevorzugt 60 Gew.-% bis 80 Gew.-% Kupfer und 20 Gew.-% bis 40 Gew.-% Zink enthält.

9. Scheibe nach einem der Ansprüche 1 bis 8, wobei die elektrisch leitfähige Struktur (2) zumindest Silber, bevorzugt Silberpartikel und Glasfritten enthält und eine Schichtdicke von 5 µm bis 40 µm aufweist.

10. Scheibe nach einem der Ansprüche 1 bis 9, wobei das Substrat (1) Glas enthält, bevorzugt Flachglas, Floatglas, Quarzglas, Borosilikatglas und/oder Kalk-Natron-Glas.

11. Scheibe nach einem der Ansprüche 1 bis 10, wobei die bleifreie Lotmasse (5) Zinn, Bismut, Indium, Zink, Kupfer, Silber und/oder Gemische und/oder Legierungen davon enthält.

12. Scheibe nach Anspruch 11, wobei die bleifreie Lotmasse (5) 35 Gew.-% bis 69 Gew.-% Bismut, 30 Gew.-% bis 50 Gew.-% Zinn, 1 Gew.-% bis 10 Gew.-% Silber und 0 Gew.-% bis 5 Gew.-% Kupfer enthält.

13. Verfahren zur Herstellung einer Scheibe nach einem der Ansprüche 1 bis 12, wobei
a) ein Verbindungssteg (4) elektrisch leitfähig auf der Oberseite des Anschlusselements (3) befestigt wird,
b) auf der Unterseite eines Anschlusselements (3) eine bleifreie Lotmasse (5) auf mindestens einer Kontaktfläche (7) aufgebracht wird,
c) das Anschlusselement (3) mit der bleifreien Lotmasse (5) auf einer elektrisch leitfähigen Struktur (2) auf einem Substrat (1) angeordnet wird und
d) das Anschlusselement (3) mit der elektrisch leitfähigen Struktur (2) verlötet wird.

14. Verfahren nach Anspruch 13, wobei der Verbindungssteg (4) anschließend durch einseitige Belastung am Ende des Verbindungsstegs (4) plastisch verformt wird.

15. Verwendung einer Scheibe nach einem der Ansprüche 1 bis 12 als Scheibe mit elektrisch leitfähigen Strukturen, bevorzugt mit Heizleitern und/oder Antennenleitern, für Fahrzeuge, Flugzeuge, Schiffe, Architekturverglasung und Gebäudeverglasung.

## Claims

1. A pane with at least one electrical connection element (3) with a connection bridge (4), comprising at least
- a substrate (1) with an electrically conductive structure (2) on at least one subregion of the substrate (1),
- at least one electrical connection element (3) on at least one subregion of the electrically conductive structure (2),
- a connection bridge (4) on at least one subregion of the connection element (3), and
- a leadfree solder material (5), which connects the electrical connection element (3) to the electrically conductive structure (2) in at least one subregion,
wherein the difference between the coefficients of thermal expansion of the substrate (1) and the connection element (3) is less than 5 x 10⁻⁶/°C,
wherein the connection bridge (4) is implemented as a solid and contains copper, and
wherein the material compositions of the connection element (3) and the connection bridge (4) are different.

2. Pane according to claim 1, wherein the electrical resistance of the connection bridge (4) is between 0.5 µOhm·cm and 20 µOhm·cm, preferably between 1.0 µOhm·cm and 15 µOhm·cm, particularly preferably between 1.5 µOhm·cm and 11 µOhm·cm.

3. Pane according to claim 1 or 2, wherein the connection element (3) contains titanium, iron, nickel, cobalt, molybdenum, copper, zinc, tin, manganese, niobium, and/or chromium and/or alloys thereof, preferably iron alloys.

4. Pane according to claim 3, wherein the connection element (3) contains at least 66.5 wt.-% to 89.5 wt.-% iron, 10.5 wt.-% to 20 wt.-% chromium, 0 wt.-% to 1 wt.-% carbon, 0 wt.-% to 5 wt.-% nickel, 0 wt.-% to 2 wt.-% manganese, 0 wt.-% to 2.5 wt.-% molybdenum, 0 wt.-% to 2 wt.-% niobium, and 0 wt.-% to 1 wt.-% titanium.

5. Pane according to claim 4, wherein the connection element (3) contains at least 77 wt.-% to 84 wt.-% iron, 16 wt.-% to 18.5 wt.-% chromium, 0 wt.-% to 0.1 wt.-% carbon, 0 wt.-% to 1 wt.-% manganese, 0 wt.-% to 1 wt.-% niobium, 0 wt.-% to 1.5 wt.-% molybdenum, and 0 wt.-% to 1 wt.-% titanium.

6. Pane according to one of claims 1 to 5, wherein the connection bridge (4) contains titanium, iron, nickel, cobalt, molybdenum, zinc, tin, manganese, niobium, silicon, chromium, and/or alloys thereof.

7. Pane according to claim 6, wherein the connection bridge (4) contains 45.0 wt.-% to 99.9 wt.-% copper, 0 wt.-% to 45 wt.-% zinc, 0 wt.-% to 15 wt.-% tin, 0 wt.-% to 30 wt.-% nickel, and 0 wt.-% to 5 wt.-% silicon.

8. Pane according to claim 7, wherein the connection bridge (4) contains 58 wt.-% to 99.9 wt.-% copper and 0 wt.-% to 37.0 wt.-% zinc, preferably 60 wt.-% to 80 wt.-% copper and 20 wt.-% to 40 wt.-% zinc.

9. Pane according to one of claims 1 to 8, wherein the electrically conductive structure (2) contains at least silver, preferably silver particles and glass frits, and has a layer thickness of 5 µm to 40 µm.

10. Pane according to one of claims 1 to 9, wherein the substrate (1) contains glass, preferably, flat glass, float glass, quartz glass, borosilicate glass, and/or soda lime glass.

11. Pane according to one of claims 1 to 10, wherein the leadfree solder material (5) contains tin, bismuth, indium, zinc, copper, silver, and/or mixtures and/or alloys thereof.

12. Pane according to claim 11, wherein the leadfree solder material (5) contains 35 wt.-% to 69 wt.-% bismuth, 30 wt.-% to 50 wt.-% tin, 1 wt.-% to 10 wt.-% silver, and 0 wt.-% to 5 wt.-% copper.

13. Method for producing a pane according to one of claims 1 to 12, wherein
a) a connection bridge (4) is electrically conductively affixed on the top of the connection element (3),
b) on the bottom of a connection element (3), a leadfree solder material (5) is applied on at least one contact surface (7),
c) the connection element (3) with the leadfree solder material (5) is arranged on an electrically conductive structure (2) on a substrate (1), and
d) the connection element (3) is soldered to the electrically conductive structure (2).

14. Method according to claim 13, wherein the connection bridge (4) is subsequently reshaped plastically by one-sided loading on the end of the connection bridge (4).

15. Use of a pane according to one of claims 1 to 12 as a pane with electrically conductive structures, preferably heating conductors and/or antenna conductors, for motor vehicles, aircraft, ships, architectural glazing, and building glazing.

## Revendications

1. Une vitre avec au moins un élément de connexion (3) avec barrette de liaison (4) comprenant au moins :
- un substrat avec une structure électriquement conductrice (2) sur au moins une région partielle du substrat (1),
- au moins un élément de connexion électrique (3) sur au moins une région partielle de la structure électriquement conductrice (2),
- une barrette de liaison (4) sur au moins une région partielle de l'élément de connexion (3), et
- une masse de soudure sans plomb (5), qui relie l'élément de connexion (3) avec au moins une région partielle de la structure électriquement conductrice (2),
où la différence entre le coefficient de dilatation thermique du substrat (1) et celui de le élément de connexion (3) est inférieure à 5 x 10⁻⁶/°C,
où la barrette de liaison (4) est formée massive et contient due cuivre, et
où la composition des matériaux de l'élément de connexion (3) et de la barrette de liaison (4) est différente.

2. Vitre selon la revendication 1, où la résistance électrique de la barrette de liaison (4) est comptée entre 0,5 µOhm·cm et 20 µOhm·cm, de préférence entre 1,0 µOhm·cm et 15 µOhm·cm, de plus préférence entre 1,5 µOhm·cm et 11 µOhm·cm.

3. Vitre selon la revendication 1 ou 2, où l'élément de connexion (3) contient du titane, du fer, du nickel, du cobalt, du molybdène, du cuivre, du zinc, de l'étain, du manganèse, du niobium et/ou du chrome et/ou des alliages de ceux-ci, de préférence des alliages de fer.

4. Vitre selon la revendication 3, où l'élément de connexion (3) contient au moins 66,5% à 89,5 % en poids de fer, 10,5% à 20 % en poids de chrome, 0% à 1% en poids de carbone, 0% à 5% en poids de nickel, 0% à 2% en poids de manganèse, 0% à 2,5% par poids de molybdène, 0 à 2% en poids de niobium et 0% à 1% en poids de titane.

5. Vitre selon la revendication 4, où l'élément de connexion (3) contient au moins 77% à 84 % en poids de fer, 16% à 18,5% en poids de chrome, 0% à 0,1% en poids de carbone, 0% à 1% en poids de manganèse, 0% à 1% en poids de niobium, 0% à 1,5% en poids de molybdène et 0% à 1% en poids de titane.

6. Vitre selon l'une des revendications 1 à 5, où la barrette de liaison (4) contient du titane, du fer, du nickel, du cobalt, du molybdène, du zinc, de l'étain, du manganèse, du niobium, du silicium, du chrome et/ou des alliages de ceux-ci.

7. Vitre selon la revendication 6, où la barrette de liaison (4) contient 45,0% à 99,9% en poids de cuivre, 0% à 45% en poids de zinc, 0% à 15% en poids d'étain, 0% à 30% en poids de nickel et 0% à 5% en poids de silicium.

8. Vitre selon la revendication 7, où la barrette de liaison (4) contient 58% à 99,9 % en poids de cuivre et 0% à 37,0% en poids de zinc, de préférence 60% à 80% en poids de cuivre et 20% à 40% en poids de zinc.

9. Vitre selon l'une des revendications 1 à 8, où la structure électriquement conductrice (2) contient au moins de l'argent, de préférence des particules d'argent et des frittes de verre et présente une épaisseur de couche de 5 µm à 40 µm.

10. Vitre selon l'une des revendications 1 à 9, où le substrat (1) contient du verre, de préférence du verre plat, du verre flotté, du verre de quartz, du verre borosilicaté et/ou du verre sodocalcique.

11. Vitre selon l'une des revendications 1 à 10, où la masse de soudure sans plomb (5) contient de l'étain, du bismuth, de l'indium, du zinc, du cuivre, de l'argent et/ou des mélanges et/ou des alliages de ceux-ci.

12. Vitre selon la revendication 11, où la masse de soudure sans plomb (5) contient 35% à 69 % en poids de bismuth, 30% à 50% en poids d'étain, 1% à 10% en poids d'argent et 0% à 5% en poids de cuivre.

13. Procédé de fabrication d'une vitre selon l'une des revendications 1 à 12, où
a) une barrette de liaison (4) est fixée de manière électriquement conductrice sur le haut de l'élément de connexion (3),
b) une masse de soudure sans plomb (5) est appliquée sur la face inférieure d'un élément de connexion (3) sur au moins une surface de contact (7),
c) l'élément de connexion (3) est disposé avec la masse de soudure sans plomb (5) sur une structure électriquement conductrice (2) sur un substrat (1) et
d) l'élément de connexion (3) est soudé à la structure électriquement conductrice (2).

14. Procédé selon la revendication 13, où la barrette de liaison (4) est ensuite déformée plastiquement par une charge unilatérale à l'extrémité de la barrette de liaison (4).

15. Utilisation d'une vitre selon l'une des revendications 1 à 12 comme vitre ayant des structures électriquement conductrices, de préférence ayant des conducteurs de chauffage et/ou des conducteurs d'antennes, pour les véhicules, les avions, les navires, le vitrage pour l'architecture et le vitrage pour le bâtiment.
